# EUROPÄISCHE PATENTANMELDUNG

(11) **EP 4 796 935 A1**
(43) Veröffentlichungstag der Anmeldung: **26.08.2026**
(21) Anmeldenummer: 26159214.1
(22) Anmeldetag: 18.02.2026
(51) Int. Cl.: G01R 15/16, G01R 31/14

(54) **SPANNUNGSPRÜF- UND ANZEIGESYSTEM MIT TEILENTLADUNGSDETEKTOR**

(30) Priorität: 25.02.2025 DE 102025107113
(71) Anmelder: H. Horstmann GmbH, 42579 Heiligenhaus (DE)
(72) Erfinder: WÜRSIG, Holger, 47239 Duisburg (DE); STAUBACH, Axel, 46282 Dorsten (DE)
(74) Vertreter: Keenway Patentanwälte Neumann Heine Taruttis

(57) **Zusammenfassung**

Ein Spannungsprüf- und -anzeigesystem (4) umfasst eine Spannungsanzeige (12) und einen Teilentladungsdetektor (16) zum Anschluss an einen elektrischen Leiter (2) über einen Spannungsteiler, wobei der Spannungsteiler aus einer Koppelkapazität (5) sowie einer Beschaltungsimpedanz (6) besteht, wobei die Beschaltungsimpedanz eine Reihenschaltung eines kapazitiven Abgleichelements (9) und eines ohmschen Widerstands (10a) oder eine Reihenschaltung eines kapazitiven Abgleichelements mit einem induktiven Widerstand (10b) ist, wobei sowohl die Spannungsanzeige als auch der Teilentladungsdetektor die über die Beschaltungsimpedanz abfallende Messspannung (11) als Eingangsspannung erhalten.

## Beschreibung

Die Erfindung betrifft ein Spannungsprüf- und -anzeigesystem mit einem Teilentladungsdetektor, insbesondere für Spannungen in Energieverteilsystemen.

Aus dem Stand der Technik sind Spannungsprüf- und -anzeigesysteme zum Prüfen des Vorhandenseins einer Spannung und einer entsprechenden Anzeige bekannt. Insbesondere in der Hoch- und Höchstspannungstechnik sind derartige Systeme als VDIS bekannt. Typischerweise verwenden diese einen rein kapazitiven Spannungsteiler, wobei an deren einer Kapazität eine Messspannung abgegriffen wird. Falls die Messspannung einen Grenzwert nicht übersteigt, so wird der entsprechende Leiter als spannungsfrei angezeigt.

In elektrischen Isolierungen können bei großen elektrischen Feldstärken Teilentladungen entstehen, wenn die Isolierung einen Defekt aufweist, beispielsweise wenn die Isolierung einen Lufteinschluss, andere Einschlüsse oder Risse aufweist. Teilentladungen sind kleine, räumlich begrenzte elektrische Entladungen, die bei Überschreiten einer kritischen elektrischen Feldstärke in den Hohlräumen oder Einschlüssen in der Isolierung stattfinden, beispielsweise in sogenannten Lunkern. Derartige Entladungen rufen einen kurzen, hochfrequenten Impuls in dem betroffenen Leiter hervor. Solche Teilentladungen entstehen beispielsweise in Spannungssystemen mit Spannungen von mehr als 1000 Volt, beispielsweise in Energieverteilsystemen, oder in umlaufenden Maschinen wie beispielsweise Generatoren oder elektrischen Umformern und damit in Systemen von weniger als 1000 Volt.

Bei längerem Einwirken oder mehrfachem Auftreten in einem solchen Hohlraum können die Entladungen die Isolierung beschädigen und nachfolgend zu einem vollständigen Durchschlag führen, sodass die Isolierung versagt und hohe Spannungen und Ströme in einen zum fehlerhaften Kabel benachbarten elektrischen Leiter durchschlagen. Bei der Herstellung neuer Schaltanlagen wird die Isolierung der Anlage auf Teilentladungen geprüft, bevor diese an ihrem Einsatzort verwendet werden.

Für das permanente Ermitteln von Teilentladungen in Kabeln wird im normgemäßen Aufbau die Spannung des Kabels mittels Auskoppelvierpol an ein Messsystem ausgekoppelt, wobei das Messsystem dazu vorgesehen und geeignet ist, anhand des ausgekoppelten Signals Teilentladungen zu ermitteln. Alternativ kann zum Ermitteln von Teilentladungen in einem Kabel ein weichmagnetischer Ring als Sensor um das Kabel gelegt werden, sodass das bei Teilentladungen durch den hochfrequenten Stromimpuls entstehende Magnetfeld in dem Sensor bzw. an einer damit verbunden Messimpedanz einen messbaren Spannungsimpuls erzeugt.

Aus der DE 101 34 790 A1 ist eine Prüfeinrichtung für Mittel- und Hochspannungsschaltanlagen bekannt, welche neben einer Spannungsprüfeinheit eine mit der Koppelelektrode eines Spannungsteilers verbindbare Teilentladungsprüfeinheit und Mittel vorsieht, um über die Koppelelektrode erfasste niederfrequente Signalanteile der Spannungsprüfeinheit und gleichzeitig über die Koppelelektrode erfasste hochfrequente Signalanteile der Teilentladungsprüfeinheit zuzuführen. Die Messspannung wird dabei für die Spannungsprüfeinheit tiefpassgefiltert und für die Teilentladungsprüfeinheit hochpassgefiltert.

Für das permanente Prüfen auf Teilentladungen während des Betriebs ist jedoch eine einfachere Messanordnung vorteilhaft.

Ein Aspekt der Erfindung betrifft eine Spannungsprüf- und Anzeigevorrichtung zum galvanischen Ankoppeln an eine Koppelkapazität, welche mit einem zu prüfenden elektrischen Leiter verbunden ist. Ebenso wie bei dem oben beschriebenen Spannungsprüf- und Anzeigesystem umfasst diese Spannungsprüf- und - anzeigevorrichtung eine Spannungsanzeige zur Anzeige des Vorhandenseins einer Spannung des elektrischen Leiters und einen Teilentladungsdetektor zur Anzeige von Teilentladungen in dem zu überwachenden elektrischen Leiter. Die Vorrichtung umfasst eine Beschaltungsimpedanz, die dazu vorgesehen ist, einerseits mit der Koppelkapazität und andererseits mit einem Bezugspotential verbunden zu werden, sodass sich ein Spannungsteiler bestehend aus der Koppelkapazität und der Beschaltungsimpedanz ergibt. Die Beschaltungsimpedanz besteht dabei erfindungsgemäß entweder aus einer Reihenschaltung eines kapazitiven Koppelelements und einem ohmschen Widerstand oder aus einer Reihenschaltung eines kapazitiven Koppelelements und einer Induktivität. Die Spannungsanzeige und der Teilentladungsdetektor erhalten jeweils dieselbe über die Beschaltungsimpedanz abfallende Spannung als Messspannung, also als Eingangsmeßgröße.

Die Spannungsprüf- und Anzeigevorrichtung kann in einer Ausführungsform weiterhin einen Spannungsbegrenzer zum Begrenzen der Meßspannung umfassen.

Nach einem weiteren Aspekt der Erfindung wird ein Spannungsprüf- und - anzeigesystem vorgeschlagen, wobei dieses eine Spannungsprüf- und - anzeigevorrichtung und eine Koppelkapazität aufweist, wobei die Spannungsprüf- und -anzeigevorrichtung über die Koppelkapazität mit dem elektrischen Leiter gekoppelt ist.

Im Folgenden wird die Erfindung näher anhand von Figuren beschrieben. Dabei zeigen
Fig. 1 eine Anordnung eines Spannungsprüf- und -anzeigesystems mit einem ohmschen Widerstand in der Beschaltungsimpedanz;
Fig. 2 einen Frequenzgang der Beschaltungsimpedanz mit 10 Hz < f < 100 MHz, die einen ohmschen Widerstand aufweist;
Fig. 3 eine Anordnung eines Spannungsprüf- und -anzeigesystems mit einer Induktivität in der Beschaltungsimpedanz;
Fig. 4 einen Frequenzgang der Beschaltungsimpedanz mi 10 Hz < f < 100 MHz, die eine Induktivität aufweist.

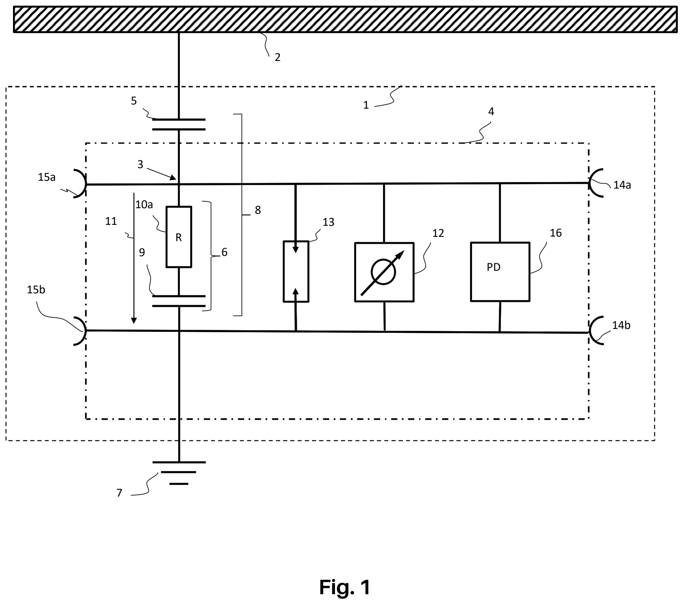

Figur 1 zeigt ein schematisches Schaltbild eines Spannungsprüf- und - anzeigesystems 1, welches mit einem elektrischen Leiter 2 und einem Bezugspotential 3 verbunden ist. Das in Fig. 1 gezeigte für einen Leiter 2 dargestellte Spannungsprüf- und Anzeigesystem ist dabei stellvertretend für entsprechende Systeme in dreiphasigen Spannungssystemen.

Der elektrische Leiter 2 kann dabei ein Kabel für Hoch- oder Höchstspannungen und große Ströme sein, d. h. für Spannungen von mehr als 1000 Volt. Alternativ kann der Leiter 2 ein spannungsführendes Element sein, welches für ein Spannungsniveau von weniger als 1000 Volt vorgesehen ist, beispielsweise eine umlaufende Maschine.

Das Spannungsprüf- und -anzeigesystem 1 umfasst eine Spannungsprüf- und anzeigevorrichtung 4 und eine Koppelkapazität 5, wobei die Spannungsprüf- und - anzeigevorrichtung 4 an einer Anschließstelle 3 über die Koppelkapazität 5 mit dem elektrischen Leiter 2 gekoppelt ist. Die Spannungsprüf- und -anzeigevorrichtung 4 weist dabei typischerweise ein Gehäuse auf, in welchem die nachfolgend beschriebenen Schaltungselemente in geeigneter Weise angeordnet sind. Die Anzeigen für die Spannungsfreiheit eines zu überwachenden elektrischen Leiters sind dabei typischerweise auf der Frontseite angeordnet, während der elektrische Anschluss an einen zu überwachenden Leiter bzw. eine Spannung sowie der Anschluss für ein Referenzpotential auf der Rückseite des Gehäuses angeordnet sind.

Die Koppelkapazität 5 ist dabei typischerweise in einem Stützer oder einer Durchführung angeordnet.

Die Spannungsprüf- und -anzeigevorrichtung 4 weist eine Beschaltungsimpedanz 6 auf, die einerseits mit der Koppelkapazität 5 und andererseits mit einem Bezugspotential 7 verbunden ist, sodass die Spannung am Ausgang der Koppelkapazität 5 der Spannungsprüf- und -anzeigevorrichtung 4 als Eingangssignal zugeführt wird. Das Bezugspotential 7 ist typischerweise das Erdpotential.

Die Beschaltungsimpedanz 6 bildet zusammen mit der Koppelkapazität 5 einen Spannungsteiler 8, wobei eine Messspannung 11 über die Beschaltungsimpedanz 6 abfällt. Die Elemente des Spannungsteilers 8 sind dabei so dimensioniert, dass die Spannung des elektrischen Leiters 2 auf eine geeignete Messspannung 11 heruntergeteilt wird, die für Messgeräte als Eingangsspannung geeignet ist.

Die Spannungsprüf- und -anzeigevorrichtung 4 umfasst eine Spannungsanzeige 12 zur Anzeige des Vorhandenseins einer Spannung, wobei die Spannungsanzeige 12 die Messspannung 11 als Eingangsspannung erhält, d.h. die Spannungsanzeige 12 erhält die mit dem Teilerverhältnis des Spannungsteilers 8 heruntergeteilte Spannung des elektrischen Leiters 2. Die Spannungsanzeige 12 zeigt dabei das Vorhandensein einer Spannung des elektrischen Leiters 2 an, wenn diese einen konfigurierten Grenzwert überschreitet. Somit zeigt die Spannungsanzeige 12 an, ob der elektrische Leiter 2 spannungsfrei ist oder an dem elektrischen Leiter 2 eine über dem konfigurierten Grenzwert liegende Spannung anliegt.

Die Spannungsprüf- und -anzeigevorrichtung 4 kann in einer Ausführungsform einen Spannungsbegrenzer 13 umfassen, der parallel zu der Spannungsanzeige 12 geschaltet ist, d.h. der parallel zu der Beschaltungsimpedanz 6 angeordnet ist. Der Spannungsbegrenzer kann dabei eine Zenerdiode oder ein Varistor oder ein anderes geeignetes Schaltungselement sein.

In einer Ausführungsform umfasst die Spannungsprüf- und -anzeigevorrichtung 4 eine frontseitige Schnittstelle 14a - 14b, an der das Bezugspotential 7 an einem Anschluss 14b sowie die Messspannung 11 an einem Anschluss 14a für einen jeden angeschlossenen elektrischen Leiter 1 abgreifbar ist.

Weiterhin kann die Spannungsprüf- und -anzeigevorrichtung 4 eine optionale Anschließstelle 15a für den Abgriff der Messspannung sowie eine Anschließstelle 15b für den Abgriff des Bezugspotentials 7 auf der Rückseite des Gehäuses aufweisen.

Die Spannungsprüf- und -anzeigevorrichtung 4 umfasst einen Teilentladungsdetektor 16, welcher ebenso wie die Spannungsanzeige 12 die über die Beschaltungsimpedanz 6 abfallende Messspannung 11 als Eingangssignal erhält. Der Teilentladungsdetektor 16 ist damit parallel zur Spannungsanzeige 12 angeordnet. Der Teilentladungsdetektor ist dazu eingerichtet, hochfrequente Signale von Teilentladungen in dem elektrischen Leiter 2 anzuzeigen. Teilentladungen in dem elektrischen Leiter 2, d.h. beispielsweise in dessen Kabelisolierung, rufen hochfrequente und typischerweise zeitlich kurze Strom- und Spannungsimpulse in dem elektrischen Leiter 2 hervor, wobei deren Spannungsamplitude im Vergleich zu der Netzspannung gering ist. Werden solche Impulse in der Spannung eines elektrischen Leiters ermittelt, so schließt man aus diesen auf Teilentladungen, welche das Kabel schädigen und zerstören. Diese hochfrequenten Impulse sind der Netzspannung überlagert, die typischerweise eine Netzfrequenz von 16 2/3 Hz oder 50 Hz oder 60 Hz aufweist.

Während es für die Spannungsprüfung in der Spannungsanzeige 12 auf die Spannung mit der Netzfrequenz ankommt, sind für den Teilentladungsdetektor 16 die hochfrequenten Impulse relevant. Der Teilentladungsdetektor 16 ist dementsprechend dazu konfiguriert und eingerichtet, hochfrequente Spannungsimpulse in seinem Eingangssignal, also der Messspannung 11 zu ermitteln und diese anzuzeigen. In einer Ausführungsform zeigt der Teilentladungsdetektor 16 eine für einen elektrischen Leiter 2 ermittelte Teilentladung nach deren Ermittlung permanent an, bis die Anzeige manuell oder ferngesteuert zurückgesetzt wird.

In einer ersten Ausführungsform besteht die Beschaltungsimpedanz aus einem ohmschen Widerstand 10a in Reihe mit einem kapazitiven Abgleichelement 9, sodass die Spannungsanzeige 12 ebenso wie der Teilentladungsdetektor 16 die über den ohmschen Widerstand 10a und das kapazitive Abgleichelement 9 abfallende Spannung jeweils als Eingangssignal erhalten.

Der Spannungsteiler 8 besteht damit in dieser Ausführungsform aus der Koppelkapazität 5 und dem der Beschaltungsimpedanz 6, die aus dem kapazitiven Abgleichelement 9 und dem frequenzunabhängigen ohmschen Widerstand 10a besteht.

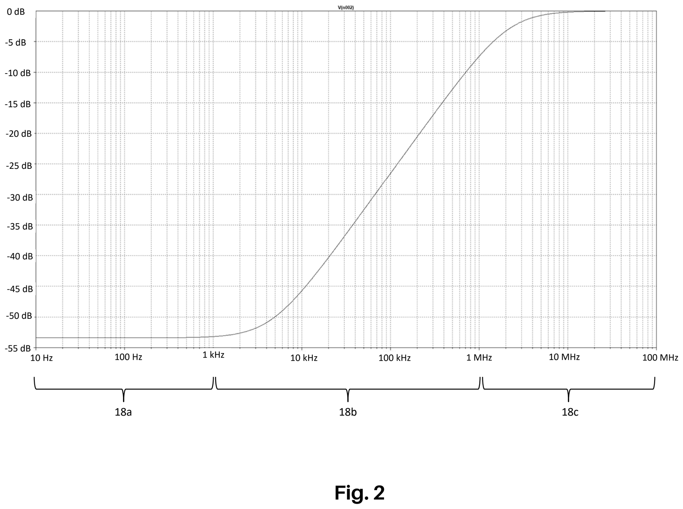

Fig. 2 zeigt einen schematischen Verlauf eines Frequenzgangs eines Spannungsteilers 8, wobei dieser aus einer Koppelkapazität 5 und einer Beschaltungsimpedanz 6 besteht, die aus einem ohmschen Widerstand 10 und einer Abgleichkapazität 9 besteht.

In Abhängigkeit von der Frequenz ist die Dämpfung der über die Beschaltungsimpedanz 6 abfallenden Messpannung 11 in Bezug auf die über den gesamten Spannungsteiler abfallende Spannung in logarithmischer Darstellung für einen Frequenzbereich von 10 Hz bis 100 MHz aufgetragen. Dabei wurden für die Koppelkapazität 5 ein Wert von *C*₁ = 7.5 × 10 ¹² Farad, für den ohmschen Widerstand 10a ein Wert von *R* = 10 kΩ und für das kapazitive Abgleichelement 9 ein Wert von*C*₇ = 3500 ×10⁻¹² Farad beispielhaft angenommen. Der Fachmann versteht, dass der Frequenzverlauf der Dämpfung von dem Verhältnis der gewählten Parameter *C₁* zu *C₂* und zu R abhängt. Dementsprechend ergibt sich, dass der Verlauf der Dämpfung, also das Teilerverhältnis des Spannungsteilers 8, in Abhängigkeit der Frequenz eingestellt werden kann.

Die Dämpfung zeigt damit den frequenzabhängigen Verlauf des Teilerverhältnisses des Spannungsteilers 8. Der Dämpfungsverlauf zeigt, dass die Dämpfung der Messspannung über die Beschaltungsimpedanz 6 in einem ersten Frequenzbereich 18a von 10 Hz bis circa 1 kHz bei nahezu konstant bei ca. -53 dB ist. In diesem Bereich ist bei den hier gewählten Werten von C₁, C₂ und R das Verhältnis der Kapazitäten für das Teilerverhältnis des Spannungsteilers maßgeblich, da der Wert des ohmschen Widerstands R für diesen ersten Frequenzbereich sehr klein und hier nahezu vernachlässigbar ist. Für Netzfrequenzen, also für einen Bereich von 16,7 Hz bis 60 Hz, ist das Verhältnis der Kapazitäten hinsichtlich des Teilerverhältnisses des Spannungsteilers 8 maßgeblich.

In einem zweiten Frequenzbereich 18b von ca. 1 kHz bis ca. 1 MHz nimmt die Dämpfung bis auf einen Wert von ca. -7,5 dB ab, da bei höheren Frequenzen die absoluten Widerstandswerte der Kapazitäten kleiner werden, wohingegen der Widerstandswert des ohmschen Widerstands 10a unabhängig von der Frequenz ist und damit an Relevanz zunimmt.

Für Frequenzen oberhalb von 1 MHz, dritter Bereich 18c, verläuft die Dämpfung dann asymptotisch gegen Null, wobei sie bei ca. 10 MHz bereits nahe Null ist.

Da Spannungsimpulse von Teilentladungen hochfrequent sind, d.h. typischerweise Frequenzen von mehr als 100 kHz aufweisen, werden diese mit dem entsprechenden Teilerverhältnis geteilt. Da für hohe Frequenzen die absoluten Widerstandswerte der Kapazitäten gegen Null gehen, der ohmsche Widerstand 10a in dem Spannungsteiler hingegen unabhängig von der Frequenz ist, fällt für hohe Frequenzen nahezu die gesamte Spannung über dem ohmschen Widerstand 10a und damit über der Beschaltungsimpedanz ab.

Bei hochfrequenten Teilentladungsimpulsen sind die absoluten Widerstandswerte der Kapazitäten nahezu vernachlässigbar, sodass über die Kapazitäten keine Spannung der Teilentladungsimpulse abfällt und die Spannungsamplitude der hochfrequenten Teilentladungsimpulse nicht durch das Verhältnis von Koppelkapazität zu Abgleichkapazität heruntergeteilt wird. Die Spannungsamplitude von hochfrequenten Teilentladungsimpulsen fällt damit nahezu ungedämpft über den ohmschen Widerstand 10a und damit über die Beschaltungsimpedanz ab. Im Unterschied zu einem herkömmlichen rein kapazitiven Spannungsteiler, der alle Spannungen unabhängig von der Frequenz gemäß dem Verhältnis der Kapazitäten herunterteilen würde, brauchen hochfrequente Teilentladungsimpulse hier nicht verstärkt zu werden, sondern steht dem Teilentladungsdetektor 16 ungedämpft als Eingangssignal zur Verfügung.

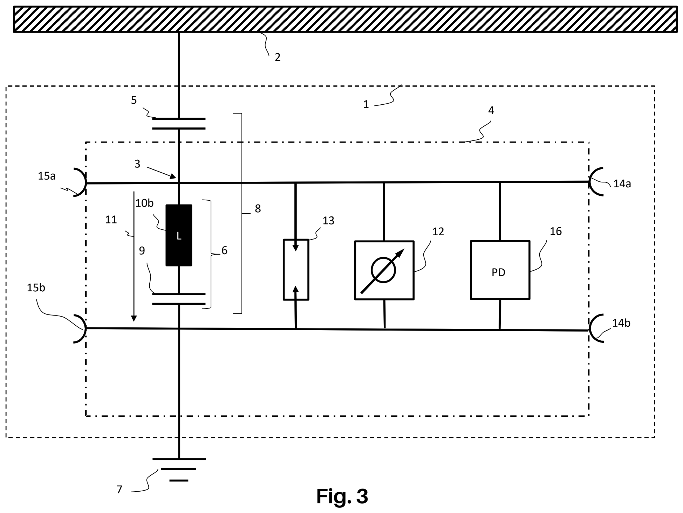

Figur 3 zeigt eine alternative Anordnung eines Spannungsprüf- und - anzeigesystems 1.

Ebenso wie die in Fig. 1 gezeigte Ausführungsform umfasst dieses alternative Spannungsprüf- und -anzeigesystem 1 eine Spannungsprüf- und anzeigevorrichtung 4 und eine Koppelkapazität 5, wobei die Spannungsprüf- und -anzeigevorrichtung 4 einerseits über die Koppelkapazität 5 mit einem elektrischen Leiter 2 und andererseits mit einem Bezugspotential 7 verbunden ist. Diese Ausführungsform umfasst auch eine Beschaltungsimpedanz 6, welche die Koppelkapazität 5 mit dem Bezugspotential 7 verbindet, sodass die Beschaltungsimpedanz 6 zusammen mit der Koppelkapazität 5 einen Spannungsteiler 8 bildet, wobei eine Messspannung 11 über die Beschaltungsimpedanz 6 abfällt. Die Spannungsprüf- und -anzeigevorrichtung 4 weist ebenso einen Spannungsbegrenzer 13 zur Begrenzung der Messspannung 11 auf, sowie eine Spannungsanzeige 12 und einen Teilentladungsdetektor 16, die jeweils die über die Beschaltungsimpedanz 6 abfallende Messspannung 11 als Eingangssignal erhalten. Weiterhin können auch bei dieser Ausführungsform die Beschaltungsimpedanz 6, der Spannungsbegrenzer 13, die Spannungsanzeige 12 sowie der Teilentladungsdetektor 16 in einem Gehäuse angeordnet sein. Optional kann die Frontseite des Gehäuses einen frontseitigen Abgriff 14b des Bezugspotentials 7 sowie der Messspannung 14a aufweisen. Auf der Rückseite des Gehäuses kann dementsprechend ebenfalls das Bezugspotential 7 sowie die Messspannung 11 an einer rückseitigen Anschließstelle 15a bereitstellen.

Die in Fig. 3 gezeigte Ausführungsform unterscheidet sich von der in Fig. 1 gezeigten Ausführungsform darin, dass die Beschaltungsimpedanz 6 aus einer Reihenschaltung einer Abgleichkapazität 9 mit einer Induktivität 10b besteht, sodass der Spannungsteiler 8 aus der Koppelkapazität 5 sowie der Reihenschaltung des kapazitiven Abgleichelements 9 und der Induktivität 10b besteht.

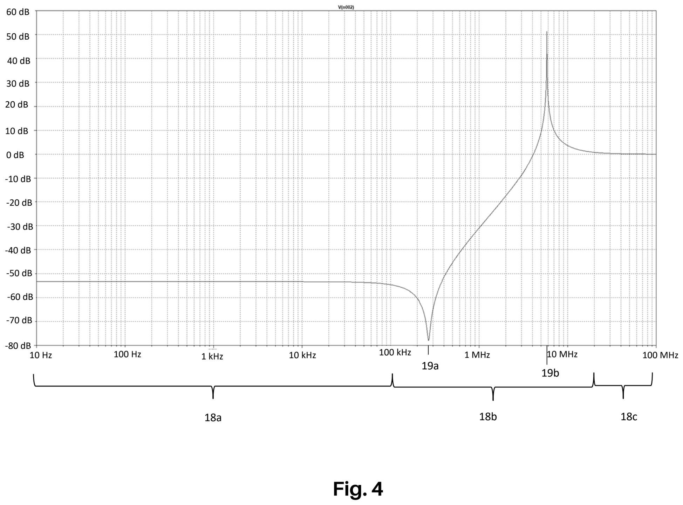

Fig. 4 zeigt den Frequenzverlauf der Dämpfung der über die Beschaltungsimpedanz 8 abfallenden Messspannung 11 im Verhältnis zur Spannung des elektrischen Leiters 2 an. Ebenso wie oben zu

In einem ersten Bereich 18a von 10 Hz bis circa 100 kHz ist die Dämpfung nahezu konstant bei circa 53 dB. Das Teilerverhältnis des Spannungsteilers 8 ist in diesem Bereich konstant und durch das Verhältnis der Kapazitätswerte bestimmt. Der Einfluss der Induktivität 10b auf das Teilerverhältnis ist in diesem Frequenzbereich vernachlässigbar.

In einem zweiten Bereich 18b von circa 100 kHz bis circa11 MHz nimmt die Dämpfung insgesamt ab, wobei der Verlauf eine erste Polstelle 19a bei der Resonanzfrequenz der Induktivität 10b mit dem kapazitiven Abgleichelement 9 und eine zweite Polstelle 19b bei der Resonanzfrequenz der Induktivität 10b mit der Koppelkapazität 5 aufweist. An der ersten Polstelle 19a, also bei der Resonanzfrequenz des induktiven Widerstands 10b mit dem kapazitiven Abgleichelement 9 ist der Widerstand über die Reihenschaltung des induktiven Widerstands und des kapazitiven Abgleichelements nahezu Null, sodass die gesamte Spannung über Koppelkapazität 5 abfällt und die Dämpfung stark zunimmt, bei den hier gewählten Werten des kapazitiven Abgleichelements und des induktiven Widerstands auf mehr als 70 dB.

Für Frequenzen höher als die erste Resonanzfrequenz nimmt die Dämpfung zunächst stark ab bis zu einer zweite Polstelle 19b, die sich an der Resonanzfrequenz der Reihenschaltung des induktiven Widerstands mit dem kapazitiven Abgleichelement ergibt, wobei die Dämpfung bis zu einem Wert größer Null zunimmt. Für die hier beispielhaft gewählten Parameter ergibt sich die Polstelle 19b bei der Resonanzfrequenz von circa 5,63 MHz. Anschließend, das heißt für Frequenzen von der zweiten Polstelle 19b bis circa 11 MHz nähert sich die Dämpfung asymptotisch 0 dB, da bei diesen hohen Frequenzen die Widerstände der Koppelkapazität sowie des kapazitiven Abgleichelements gegen Null gehen, der Widerstandswert des induktiven Widerstands 10b jedoch mit steigender Frequenz zunimmt. Für steigende Frequenzen nimmt damit der gesamte Widerstand des Beschaltungsimpedanz 6 zu während der Widerstandswert der Koppelkapazität 5 immer kleiner wird, sodass nahezu die gesamte Spannung über den Spannungsteiler 8 ausschließlich an der Beschaltungsimpedanz abfällt und das Teilerverhältnis und die Dämpfung nahezu bei Null bleibt. Hochfrequente Teilentladungsimpulse werden folglich nicht mit dem Teilerverhältnis von Koppelkapazität 5 zu kapazitiven Abgleichelement 9 heruntergeteilt, sondern stehen dem Teilentladungsdetektor ungedämpft zur Verfügung.

Das frequenzabhängige Verhalten der beiden Ausführungsformen der Beschaltungsimpedanz bewirkt, dass das Teilerverhältnis des Spannungsteilers 8 in Abhängigkeit des Wertes des ohmschen Widerstands 10a oder alternativ des induktiven Widerstands für die typischen Netzfrequenzen von unterhalb 100 Hz im Wesentlichen von dem Verhältnis der Koppelkapazität 5 zum kapazitiven Abgleichelement 9 bestimmt wird, wohingegen für Signale höherer Frequenz das Teilerverhältnis von dem ohmschen Widerstand oder von dem induktiven Widerstand bestimmt wird, sodass durch Teilentladungen hervorgerufene Spannungsimpulse mit geringerer Dämpfung dem Teilentladungsdetektor als Eingangssignal bereitgestellt werden.

### Bezugszeichenliste

- 1: Spannungsprüf- und -anzeigesystem
- 2: Elektr. Leiter
- 3: Anschließstelle für Koppelkapazität
- 4: Spannungsprüf- und -anzeigevorrichtung
- 5: Koppelkapazität
- 6: Beschaltungsimpedanz
- 7: Bezugspotential, Erdpotential
- 8: Spannungsteiler
- 9: kapazitives Abgleichelement
- 10a: ohmscher Widerstand
- 10b: induktiver Widerstand
- 11: Messspannung
- 12: Spannungsanzeige
- 13: Spannungsbegrenzer
- 14a: frontseitige Schnittstelle f. Messspannung
- 14b: frontseitiger Abgriff des Bezugspotentials
- 15a: rückseitige Anschließstelle
- 15b: rückseitiger Abgriff des Bezugspotentials
- 16: Teilentladungsdetektor
- 17: Dämpfung bei einem ohmschen Widerstand in der Beschaltungsimpedanz
- 18a: erster Frequenzbereich
- 18b: zweiter Frequenzbereich
- 18c: dritter Frequenzbereich
- 19a: erste Polstelle
- 19b: zweite Polstelle

## Patentansprüche

1. Spannungsprüf- und -anzeigevorrichtung (4) zum galvanischen Ankoppeln an eine Koppelkapazität (5), welche mit einem zu prüfenden elektrischen Leiter (2) verbunden ist,
wobei die Spannungsprüf- und anzeigevorrichtung (4)
eine Beschaltungsimpedanz (6) umfasst, welche die Koppelkapazität (5) mit einem Bezugspotential (7) verbindet, und
eine Spannungsanzeige (12) zur Anzeige der Spannung des elektrischen Leiters (2), wobei die Spannungsanzeige (12) die über die Beschaltungsimpedanz (6) abfallende Spannung als Messspannung (11) erhält, und
einen Teilentladungsdetektor (16) zur Ermittlung von Teilentladungen in dem elektrischen Leiter (2) umfasst,
**dadurch gekennzeichnet,**
**dass** die Beschaltungsimpedanz (6) aus einem ohmschen Widerstand (10a) in Reihe zu einem kapazitiven Abgleichelement (9) oder aus einer Induktivität (10b) in Reihe zu dem kapazitiven Abgleichelement (9) besteht, und
**dass** der Teilentladungsdetektor (16) die Messspannung (11) als Eingangssignal erhält.

2. Spannungsprüf- und -anzeigevorrichtung (4) nach Anspruch 1, wobei die Spannungsprüf- und -anzeigevorrichtung (4) für Spannungen von mehr als 1000 Volt vorgesehen ist.

3. Spannungsprüf- und -anzeigevorrichtung (4) nach einem der vorstehenden Ansprüche, wobei das Verhältnis zwischen der Koppelkapazität (5) und dem kapazitiven Abgleichelement (9) mindestens 10 und höchstens 1000 beträgt.

4. Spannungsprüf- und -anzeigevorrichtung (4) nach einem der vorstehenden Ansprüche, wobei die Spannungsprüf- und -anzeigevorrichtung (4) ein Gehäuse aufweist und wobei die Beschaltungsimpedanz (6) und die Spannungsanzeige (12) und der Teilentladungsdetektor (16) in dem Gehäuse angeordnet sind.

5. Spannungsprüf- und -anzeigevorrichtung (4) nach Anspruch 4, wobei das Gehäuse auf einer Frontseite eine Anschließstelle für die Messspannung (11) umfasst.

6. Spannungsprüf- und -anzeigevorrichtung (4) nach einem der vorstehenden Ansprüche, wobei die Spannungsprüf- und -anzeigevorrichtung (4) einen Spannungsbegrenzer (13) aufweist, der elektrisch parallel zu der Beschaltungsimpedanz (6) angeordnet ist.

7. Spannungsprüf- und anzeigesystem umfassend
eine Spannungsprüf- und -anzeigevorrichtung (4) nach einem der vorstehenden Ansprüche und eine Koppelkapazität (5), wobei die Beschaltungsimpedanz (6) der Spannungsprüf- und -anzeigevorrichtung (4) über die Koppelkapazität (5) mit einem elektrischen Leiter (2) verbunden ist.
